# EUROPEAN PATENT SPECIFICATION

(11) **EP 4 199 129 B1**
(45) Date of publication and mention of the grant of the patent: **04.12.2024**
(21) Application number: 22818603.7
(22) Date of filing: 08.09.2022
(51) Int. Cl.: H10K 59/80, H10K 59/131

(54) **DISPLAY PANEL AND ELECTRONIC DEVICE**
ANZEIGETAFEL UND ELEKTRONISCHE VORRICHTUNG
ÉCRAN D'AFFICHAGE ET DISPOSITIF ÉLECTRONIQUE

(30) Priority: 12.10.2021 CN 202111188690
(43) Date of publication of application: 21.06.2023
(73) Proprietor: Honor Device Co., Ltd., Shenzhen, Guangdong 518040 (CN)
(72) Inventor: MA, Lei, Guangdong 518040 (CN); TANG, Jiehua, Guangdong 518040 (CN); WANG, Peng, Guangdong 518040 (CN)
(74) Representative: Gill Jennings & Every LLP
(86) International application number: PCT/CN2022/117731
(87) International publication number: WO 2023/061114

(56) References cited:
- CN-A- 104 393 188
- CN-A- 109 817 671
- CN-A- 110 854 290
- CN-A- 111 524 956
- CN-A- 113 270 558
- CN-A- 115 000 123
- CN-U- 210 349 841
- CN-U- 210 349 841
- US-A1- 2012 074 423
- US-A1- 2019 067 396
- US-A1- 2021 135 149

## Description

### TECHNICAL FIELD

This application relates to the field of display technologies, and in particular, to a display panel and an electronic device including the display panel.

### BACKGROUND

With development of display technologies, display devices are more widely used, and are gradually applied to various aspects of people's work and life. Organic light-emitting diode display devices have received extensive attention because of their advantages such as small thickness, high brightness, low power consumption, fast response, high definition resolution, good flexibility, and high luminous efficiency. However, when an existing organic light-emitting diode display device is in use, a display picture often has non-uniform display brightness. Therefore, how to improve display brightness uniformity of an organic light-emitting diode display device becomes a research focus of a person skilled in the art.

US 2019/067396 A1 discusses an organic light-emitting diode (OLED) array substrate, a method for manufacturing an organic light-emitting diode (OLED) array substrate and a display apparatus. US 2021/135149 A1 discusses a display panel, a method for fabricating a display panel and a display apparatus.

CN 109 817 671 A discusses a display panel which comprises a substrate which is provided with pixel areas distributed in an array mode, an anode layer distributed on the substrate in an array manner corresponding to the pixel areas, a light-emitting layer arranged on the anode layer corresponding to the pixel areas, a cathode layer arranged on the light-emitting layer, and an auxiliary electrode which is insulated from the anode layer, is arranged on the substrate corresponding to a gap position between two adjacent pixel areas, and is in parallel contact with the cathode layer through contact holes, wherein the edge area of at least one side of the substrate is not provided with contact holes, or the distribution density of the contact holes in the edge area of the substrate is smaller than that of the contact holes in other areas. US 2012/074423 A1 discusses an EL display panel includes an organic EL device and a thin film semiconductor unit.

### SUMMARY

This application provides a display panel, so as to improve display brightness uniformity of an organic light-emitting diode display device. To achieve the foregoing objective, the following technical solutions are provided in this application:

According to a first aspect, an embodiment of this application is provided according to appended claim 1. Therefore, resistance of the part that is of the cathode layer and that is in the display area is reduced by connecting the part of the first electrode layer in parallel to the part that is of the cathode layer and that is in the display area, so that a voltage difference between a part that is of the cathode layer and that is close to a signal input end (that is, a part that is close to a flexible circuit board) and a part that is of the cathode layer and that is away from the signal input end (that is, a part that is away from the flexible circuit board), thereby alleviating non-uniform display brightness of the display panel caused by a large voltage difference between parts of the cathode layer that are in different parts of the display area, and improving display quality of the display panel.

In addition, according to the display panel provided in this embodiment of this application, resistance of the part that is of the cathode layer and that is in the border area is reduced by connecting the part of the first electrode layer in parallel to the part that is of the cathode layer and that is in the border area, so as to reduce a signal transmission loss of the part that is of the cathode layer and that is in the border area, thereby reducing a signal transmission loss that is output by the flexible circuit board and that is transmitted to the part that is of the cathode layer and that is in the display area, and reducing power consumption of the display panel while display brightness of the display panel is fixed.

The display panel further includes: an anode layer located on a side that is of the cathode layer and that faces the first substrate; a pixel definition layer and a light-emitting layer that are located between the anode layer and the cathode layer, where the pixel definition layer includes a plurality of pixel definition areas, the light-emitting layer includes a plurality of light-emitting units, and the light-emitting units are in a one-to-one correspondence with the pixel definition areas and are located in the pixel definition areas; and a control circuit layer located on a side that is of the anode layer and that is away from the cathode layer.

The first electrode layer is located on a side that is of the anode layer and that is away from the cathode layer, so as to shorten a distance between the first electrode layer and the flexible circuit board, which facilitates signal transmission between the first electrode layer and the flexible circuit board; and arrangement of the first electrode layer does not affect a light-emitting area of the light-emitting unit, and layout and arrangement of each electrode line in the first electrode may be determined based on an actual use requirement, so as to accurately adjust resistance of the cathode layer around each light-emitting unit, and implement more accurate cathode layer resistance control, so that resistance of the display area of the display panel is more balanced.

The first electrode layer is located between the anode layer and the control circuit layer.

In another implementation, there is a first insulation layer between the control circuit layer and the first electrode layer, so as to implement electrical insulation between the control circuit layer and the first electrode layer by using the first insulation layer; and there is a second insulation layer between the first electrode layer and the anode layer, so as to implement electrical insulation between the first electrode layer and the anode layer by using the second insulation layer, where the control circuit layer is electrically connected to the anode layer by using a first via, and the first electrode layer is electrically connected to the cathode layer by using a second via.

In still another implementation, the second via penetrates a gap between adjacent light-emitting units, so as to avoid that arrangement of the second via affects the light-emitting area of the light-emitting unit.

A projection of the first electrode layer on a plane on which the first substrate is located at least partially overlaps with a projection of the light-emitting layer on the plane on which the first substrate is located.

In still another implementation, the first electrode layer is located on a side that is of the anode layer and that faces the cathode layer.

In another implementation, there is a third insulation layer between the anode layer and the first electrode layer, and there is a fourth insulation layer between the first electrode layer and the cathode layer, so that a forming surface of the cathode layer is a flat surface by using the fourth insulation layer.

In still another implementation, the first electrode layer includes a plurality of first electrode lines, the plurality of light-emitting units include a plurality of rows of light-emitting units, the first electrode lines extend in a row direction, and projection of the first electrode line on the plane on which the first substrate is located is within a projection range of a gap between adjacent rows of the light-emitting units on the plane on which the first substrate is located.

In still another implementation, the first electrode layer further includes a plurality of second electrode lines, the second electrode lines extend in a column direction, the plurality of light-emitting units include a plurality of columns of light-emitting units, and projection of the second electrode line on the plane on which the first substrate is located is within a projection range of a gap between adjacent columns of the light-emitting units on the plane on which the first substrate is located.

In still another implementation, a shape of an electrode line at the first electrode layer is a wave shape or a broken line shape.

According to a second aspect, an embodiment of this application further provides an electronic device, where a display of the electronic device includes the display panel according to any one of the foregoing, so as to improve uniformity of display brightness when the electronic device displays a picture, and reduce power consumption of the electronic device while the display brightness of the display panel is fixed.

### BRIEF DESCRIPTION OF DRAWINGS

FIG. 1 is a schematic diagram of an application scenario of a display panel;
FIG. 2 is a top view of a current display panel;
FIG. 3 is a sectional view of a structure of a current display panel;
FIG. 4 is a sectional view of a display panel according to an embodiment of this application;
FIG. 5 is a sectional view of a display panel according to another embodiment of this application;
FIG. 6 is a sectional view of a display panel according to still another embodiment of this application;
FIG. 7 is a schematic diagram of a relative position of a first electrode layer and a light-emitting unit in a display panel according to an embodiment of this application;
FIG. 8 is a schematic diagram of different areas on a surface that is of a cathode layer and that is away from an anode layer;
FIG. 9 is a sectional view of a display panel according to yet another embodiment (not forming part of the claimed invention);
FIG. 10 is a schematic diagram of a relative position of a first electrode layer and a light-emitting unit in a display panel according to another embodiment (not forming part of the claimed invention);
FIG. 11 is a schematic diagram of a relative position of a first electrode layer and a light-emitting unit in a display panel according to still another embodiment (not forming part of the claimed invention);
FIG. 12 is a schematic diagram of a relative position of a first electrode layer and a light-emitting unit in a display panel according to yet another embodiment (not forming part of the claimed invention);
FIG. 13 is a schematic diagram of a shape of an electrode line at a first electrode layer in a display panel according to an embodiment of this application; and
FIG. 14 is a schematic diagram of a structure of an electronic device according to an embodiment of this application.

### DESCRIPTION OF EMBODIMENTS

In the specification, claims, and accompanying drawings of this application, the terms "first", "second", "third", and the like are intended to distinguish between different objects but not to limit a particular order.

In embodiments of this application, the word such as "as an example" or "for example" is used to represent giving an example, an illustration, or a description. In embodiments of this application, any embodiment or design solution described as "as an example" or "for example" shall not be explained as being preferred or advantageous over other embodiments or design solutions. To be precise, the use of the word such as "as an example" or "for example" is intended to present a related concept in a specific manner.

For clarity and brevity of the following embodiments, a brief description of a related technology is first provided.

An OLED (Organic Light-Emitting Diode, Organic Light-Emitting Diode), which is also referred to as an organic electric laser display and an organic electroluminescence display (Organic Electroluminescence Display, OLED), refers to a semiconductor structure in which an organic semiconductor material and a light-emitting material emit light through carrier injection and recombination when being driven by an electric field.

A flexible printed circuit (Flexible Printed Circuit, FPC for short) is a highly reliable and excellent flexible printed circuit board made of Polyimidepolyimide or polyester film.

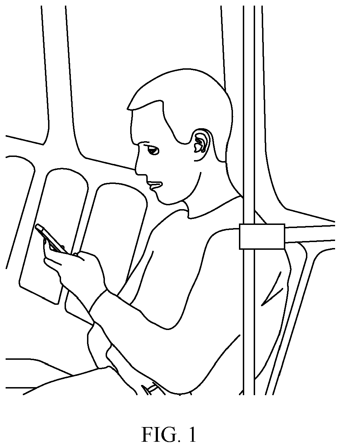

As shown in FIG. 1, FIG. 1 is a schematic diagram of an application scenario of an OLED display panel. In daily life, a user often swipes a mobile phone when the user is on the way of transportation or in leisure time, and watches a video, browses a web page, plays a game, and the like by using an OLED display panel. In a process of swiping the mobile phone, the OLED display panel needs to constantly update a display picture of the OLED display panel, to update a displayed image and/or displayed text, so as to meet a viewing and display requirements of the user.

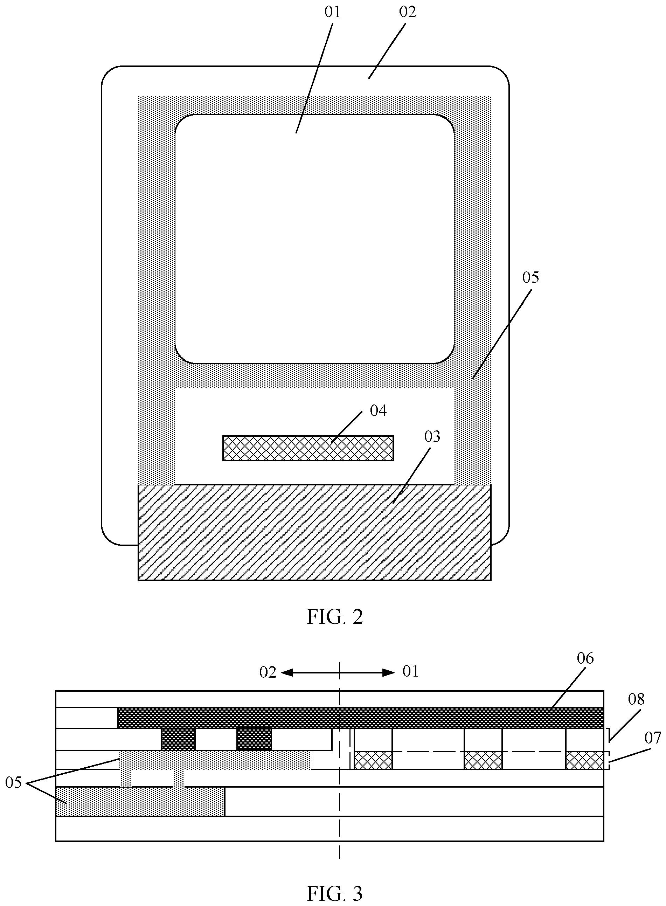

As shown in FIG. 2, FIG. 2 shows a top view of an OLED display panel. The OLED display panel includes a display area 01 and a border area 02, where a plurality of OLED light-emitting units are disposed in the display area 01, a flexible circuit board FPC03 and an integrated circuit board IC04 are disposed in the border area 02, the integrated circuit board IC04 is electrically connected to the flexible circuit board FPC03, and the flexible circuit board FPC03 is electrically connected to each OLED light-emitting unit in the display area 01 through an electrical connection line 05. During specific operation, the integrated circuit board IC04 transmits a drive signal to the electrical connection line 05 by using the flexible circuit board FPC03, and then transmits the drive signal to each OLED light-emitting unit in the display area 10 by using the electrical connection line 05, so as to control each OLED light-emitting unit to emit light, so that the OLED display panel displays a display picture.

As shown in FIG. 3, FIG. 3 is a sectional view of a structure of an OLED display panel. The display area 01 of the OLED display panel includes an anode layer 07 and a cathode layer 06 that are disposed opposite to each other, and a light-emitting layer 08 located between the anode layer 07 and the cathode layer 06, where the anode layer 07 includes a plurality of anodes, the light-emitting layer 08 includes a plurality of light-emitting units, and the anodes are in a one-to-one correspondence with the light-emitting units. Therefore, when the OLED display panel is in operation, each of the light-emitting units can be controlled to emit light by applying a voltage to the cathode layer and the anodes corresponding to the light-emitting units.

As shown in FIG. 3, in a current OLED display panel, the cathode layer 06 further extends to the border area 02, and is connected to the flexible circuit board through the electrical connection line 05 located in the border area 02, so that the integrated circuit board located in the border area may apply a voltage to the cathode layer by using the flexible circuit board and the electrical connection line sequentially. In actual application, because a display area of the OLED display panel is relatively large, a difference between a voltage of one end that is of the cathode layer 06 and that is close to the electrical connection line 05 and a voltage of one end that is of the cathode layer 06 and that is away from the electrical connection line 05 increases, and causes non-uniform display brightness of the display picture. For example, display brightness of one end that is of the display and that is close to the circuit board is different from display brightness of one end that is of the display picture and that is away from the circuit board, and/or display brightness of a central area of the display picture is different from display brightness of an edge area of the display picture.

In addition, the electrical connection line 05 that electrically connects the cathode layer 06 and the flexible circuit board is relatively long, so that a signal output by the flexible circuit board is transmitted to the cathode layer with a high loss, which causes a high power consumption of the OLED display panel.

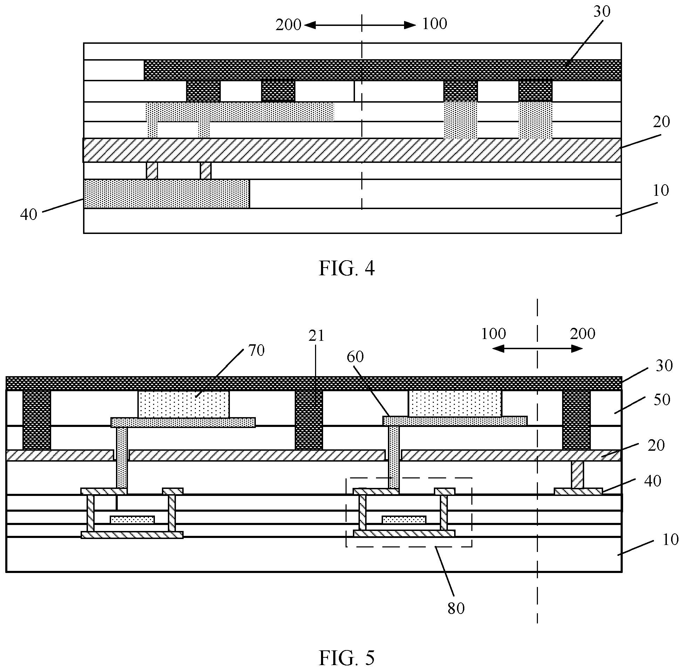

In view of this, an embodiment of this application provides a display panel. As shown in FIG. 4, the display panel includes:
a first substrate 10;
a first electrode layer 20 located on a side of the first substrate 10; and
a cathode layer 30 located on a side that is of the first electrode layer 20 and that is away from the first substrate 10; where
the cathode layer 30 covers a display area 100 of the display panel, and extends to a border area 200 of the display panel; and a part of the first electrode layer 20 is located in the display area 100 of the display panel, and is connected in parallel to a part that is of the cathode layer 30 and that is in the display area 100, and a part of the first electrode layer 20 is located in the border area 200 of the display panel, and is connected in parallel to a part that is of the cathode layer 30 and that is in the border area 200.

During specific operation, a flexible circuit board and an integrated circuit board are further bound to the border area of the display panel. As shown in FIG. 4, in this embodiment of this application, the cathode layer 20 is electrically connected to the subsequently bound flexible circuit board through an electrical connection line 40, and the flexible circuit board is electrically connected to the integrated circuit board, so that the integrated circuit board provides a voltage signal for the cathode layer by using the flexible circuit board and the electrical connection cable 40 sequentially.

As shown in FIG. 5, in this embodiment of this application, in addition to the first substrate, the cathode layer, and the first electrode layer, the display panel further includes: an anode layer located on a side that is of the cathode layer 30 and that faces the first substrate 10, where the anode layer includes a plurality of anode units 60; a pixel definition layer 50 and a light-emitting layer that are located between the anode layer and the cathode layer 30, where the pixel definition layer 50 includes a plurality of pixel definition areas, the light-emitting layer includes a plurality of light-emitting units 70, and the light-emitting units 70 are in a one-to-one correspondence with the pixel definition areas and are located in the pixel definition areas; and a control circuit layer located on a side that is of the anode layer and that is away from the cathode layer 30, where the control circuit layer includes a plurality of control units 80. In this embodiment, the control units are in a one-to-one correspondence with the anode units and the light-emitting units, so as to control a light-emitting status of the light-emitting units by controlling a voltage value applied to the anode units.

Optionally, in an embodiment of this application, the plurality of light-emitting units include light-emitting units of three colors: a red light-emitting unit, a blue light-emitting unit, and a green light-emitting unit, so that the display panel implements display of a color picture. However, this is not limited in this application, and may be specifically determined based on a situation.

It should be noted that, when the flexible circuit board and the integrated circuit board are bound to the border area of the display panel, the control unit controls a connection status of a path between the anode unit and the flexible circuit board, and when the control unit controls the path between the anode unit and the flexible circuit board to be connected, the integrated circuit board applies a first voltage to the anode unit by using the flexible circuit board and the control unit sequentially, and applies a second voltage to the first electrode layer by using the flexible circuit board, where the first voltage is different from the second voltage, so that a voltage difference is formed on two sides of the light-emitting unit, and the light-emitting unit is controlled to display.

It may be learned from the foregoing that, in addition to the first substrate and the cathode layer, the display panel provided in this embodiment of this application further includes a first electrode layer that is connected in parallel to the cathode layer, so as to reduce resistance of a part that is of the cathode layer and that is in the display area by connecting a part of the first electrode layer in parallel to the part that is of the cathode layer and that is in the display area, and then reduce a voltage difference between a part that is of the cathode layer and that is close to a signal input end (that is, a part that is close to the flexible circuit board) and a part that is of the cathode layer and that is away from the signal input end (that is, a part that is away from the flexible circuit board), thereby alleviating non-uniform display brightness of the display panel caused by a large voltage difference between parts of the cathode layer that are in different parts of the display area, and improving display quality of the display panel.

In addition, according to the display panel provided in this embodiment of this application, resistance of the part that is of the cathode layer and that is in the border area is reduced by connecting the part of the first electrode layer in parallel to the part that is of the cathode layer and that is in the border area, so as to reduce a signal transmission loss of the part that is of the cathode layer and that is in the border area, thereby reducing a signal transmission loss that is output by the flexible circuit board and that is transmitted to the part that is of the cathode layer and that is in the display area, and reducing power consumption of the display panel while display brightness of the display panel is fixed.

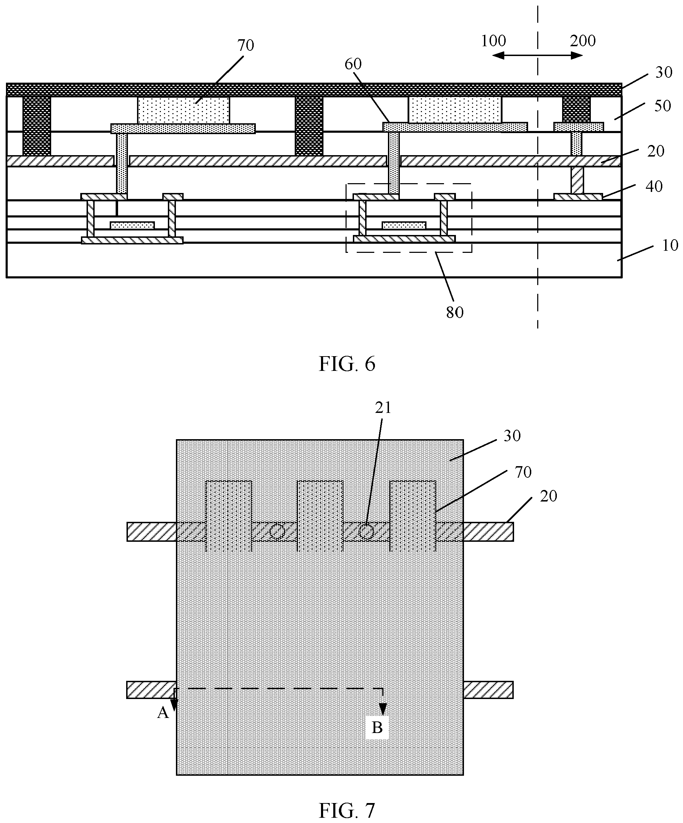

Based on any one of the foregoing embodiments, in an embodiment of this application, as shown in FIG. 5 and FIG. 6, the first electrode layer 20 is located on a side that is of the anode layer and that is away from the cathode layer 30, that is, the first electrode layer 20 is located on a side that is of the anode unit 60 and that is away from the cathode layer 30, so as to shorten a distance between the first electrode layer and the flexible circuit board, which facilitates signal transmission between the first electrode layer and the flexible circuit board. It should be noted that, in this embodiment, the cathode layer 30 may be electrically connected to the first electrode layer 20 directly through a via. As shown in FIG. 5, the cathode layer 30 may be electrically connected to the first electrode layer 20 by using an electrical connection structure that is located on a same layer as the anode unit 60. As shown in FIG. 6, this is not limited in this application, and may be specifically determined based on a situation.

Based on the foregoing embodiments, in an embodiment of this application, the first electrode layer is located between the anode layer and the control circuit layer, that is, the first electrode layer 20 is located between a film layer in which the anode unit 60 is located and a film layer in which the control unit 80 is located, as shown in FIG. 5 and FIG. 6. It should be noted that, in this embodiment, the first electrode layer is located on a side that is of the anode unit 60 and that is away from the light-emitting unit 70. Therefore, in this embodiment of this application, arrangement of the first electrode layer does not affect a light-emitting area of the light-emitting unit, and layout and arrangement of each electrode line in the first electrode may be determined based on an actual use requirement, so as to accurately adjust resistance of the cathode layer around each light-emitting unit, and implement more accurate cathode layer resistance control, so that the resistance of the display area of the display panel is more balanced.

It should be further noted that, in this embodiment of this application, in a process in which the signal output by the flexible circuit board is transmitted from one end that is of the cathode layer and that is close to the signal input end to one end that is of the cathode layer and that is away from the signal input end, a voltage difference increases. Therefore, in this embodiment of this application, in a direction in which the end that is of the cathode layer and that is close to the signal input end points to the end that is of the cathode layer and that is away from the signal input end, resistance of the cathode layer corresponding to each light-emitting unit is adjusted by adjusting the part of the first electrode layer corresponding to an area in which each light-emitting unit is located, so that display brightness of the display panel is more uniform.

The projection of the first electrode layer on a plane on which the first substrate is located at least partially overlaps with projection of the light-emitting layer on the plane on which the first substrate is located. For example, a part of the first electrode layer is located directly below the light-emitting unit, which is not limited in this application. In another embodiment of this application (not forming part of the claimed invention), the projection of the first electrode layer on the plane on which the first substrate is located may not overlap with the projection of the light-emitting layer on the plane on which the first substrate is located, and this may be specifically determined based on a situation.

Based on the foregoing embodiments, in an embodiment of this application, there is a first insulation layer between the control circuit layer and the first electrode layer, so as to implement electrical insulation between the control circuit layer and the first electrode layer by using the first insulation layer. Similarly, there is a second insulation layer between the first electrode layer and the anode layer, so as to implement electrical insulation between the first electrode layer and the anode layer by using the second insulation layer. It should be noted that, in this embodiment of this application, the first electrode layer and the cathode layer are not at a same film layer, and the anode layer and the control circuit layer are not at a same film layer. Therefore, in a specific embodiment of this application, the control circuit layer is electrically connected to the anode layer through a first via, and the first electrode layer is electrically connected to the cathode layer through a second via. However, this is not limited in this application, and may be specifically determined based on a situation.

It should be noted that, in this embodiment of this application, the first electrode layer is located on a side that is of the anode unit and that is away from the light-emitting unit, and the cathode layer is located on a side that is of the light-emitting unit and that is away from the anode unit, that is, the first electrode layer and the anode layer are respectively located on two sides of the light-emitting unit. To avoid that arrangement of the second via affects the light-emitting area of the light-emitting unit, in an optional embodiment of this application, as shown in FIG. 5 and FIG. 7, FIG. 5 is a sectional view of FIG. 7 along AB, and the second via 21 penetrates a gap between adjacent light-emitting units 70, that is, projection of the first via 21 on the plane on which the first substrate is located is within a projection range of the gap between the adjacent light-emitting units 70 on the plane on which the first substrate is located. This is not specifically limited in this application, and may be specifically determined based on a situation.

Based on any one of the foregoing embodiments, in an embodiment of this application, the first insulation layer is a planarization layer, so as to improve flatness of a formation plane of the first electrode layer and reduce difficulty of a process of the first electrode layer; and the second insulation layer is a planarization layer, so as to improve flatness of a formation plane of the anode layer and reduce difficulty of a process of the anode layer.

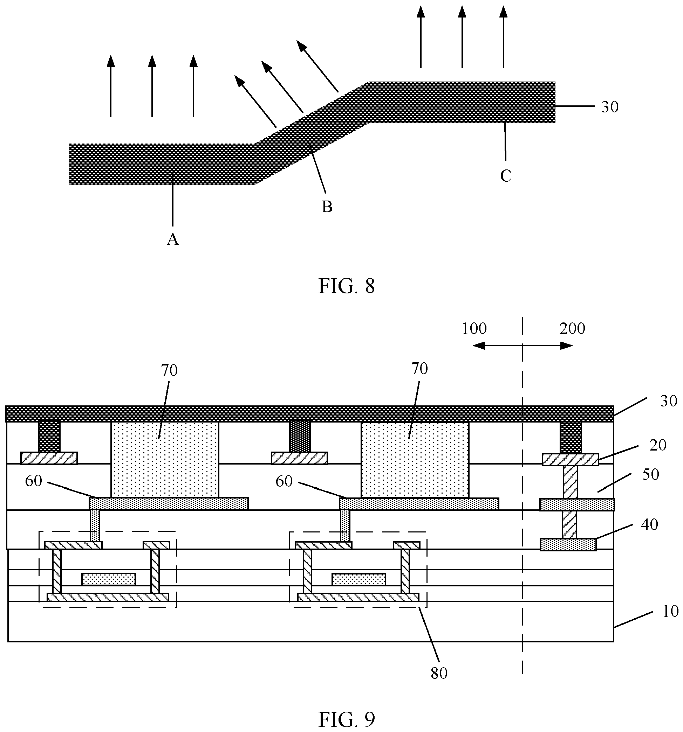

It should be noted that, when different areas of a surface that is of the cathode layer and that is away from the anode layer side are not on a same plane, as shown in FIG. 8, for example, a surface that is of the cathode layer 30 and that is away from the anode layer side includes a first area A, a second area B, and a third area C, and the first area A, the second area B, and the third area C are located on different planes. A plane on which the first area A is located and a plane on which the third area C is located are parallel, and the second area B is connected to the first area A and the third area C. During specific operation, light emitted from the first area A is parallel to light emitted from the third area C, light emitted from the second area B is not parallel to the light emitted from the first area A, so that the light emitted from the second area B and the light emitted from the first area A overlap each other in some areas, intensity of light in the areas is increased, and lights in some areas do not overlap each other, and the light intensity of the light emitted from the first area is maintained. Therefore, intensity of light emitted from different areas of a surface that is of the cathode layer and that is away from the anode layer is different, light in some areas is relatively strong, and light in some areas is relatively weak, thereby generating a light shadow phenomenon.

However, in this embodiment of this application, the first electrode layer is located on a side that is of the anode layer and that is away from the cathode layer, and is relatively far from the cathode layer, so that even if the first electrode layer is in a form of a non-integral surface electrode, its influence on flatness of a formation plane of the first electrode layer corresponding to the first electrode layer is relatively small, and flatness of the formation plane of the cathode layer is ensured. In this way, different areas of a surface that is of the cathode layer and that is away from the anode layer are on a same plane, to avoid a light shadow phenomenon when different areas of the surface that is of the cathode layer and that is away from the anode layer are not on a same plane.

In another embodiment of this application (not forming part of the claimed invention), as shown in FIG. 9, the first electrode layer 20 is located on a side that is of the anode layer and that faces the cathode layer 30, that is, the first electrode layer 20 is located between the pixel definition layer 50 and the cathode layer 30. Optionally, in this embodiment of this application, still as shown in FIG. 9, there is a fourth insulation layer between the first electrode layer 20 and the cathode layer 30, so that a formation surface of the cathode layer 30 is a flat surface by using the fourth insulation layer.

It should be noted that, when the first electrode layer is located between a film layer at which the light-emitting unit is located and the cathode layer, if the first electrode layer is disposed above the light-emitting unit, the light-emitting area of the light-emitting unit is affected. Optionally, based on the foregoing embodiments, in an embodiment of this application, projection of the first electrode layer on a plane on which the first substrate is located does not overlap with projection of the light-emitting layer on a plane on which the first substrate is located, thereby avoiding arrangement of the first electrode layer to affect the light-emitting area of the display panel.

It should be further noted that, in this embodiment of this application, the light-emitting unit 70 can emit light only under joint control of the anode unit 60 and the cathode layer 30. Therefore, in this embodiment of this application, the fourth insulation layer is provided with an opening that is in a one-to-one correspondence with the pixel definition area, and the opening is connected to the pixel definition area, so that a part of the light-emitting unit 70 is located in the pixel definition area and is electrically connected to the anode unit 60, and a part of the light-emitting unit 70 is located in the opening of the fourth insulation layer and is electrically connected to the cathode layer 30.

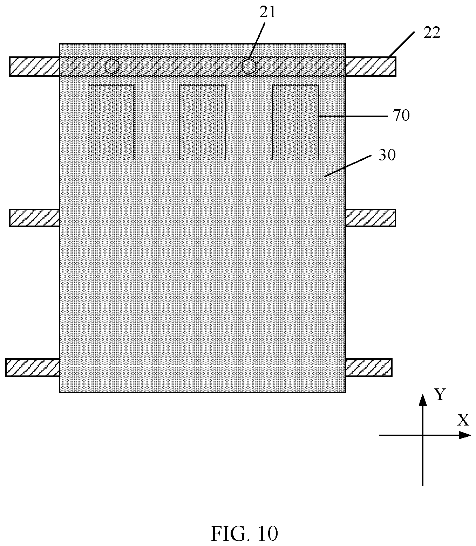

Based on any one of the foregoing embodiments, in an embodiment of this application (not forming part of the claimed invention), as shown in FIG. 10, the first electrode layer includes a plurality of first electrode lines 22, the plurality of light-emitting units include a plurality of rows of light-emitting units, the first electrode line 22 extends in a row direction X, and projection of the first electrode line 22 on the plane on which the first substrate is located is within the projection range of a gap between adjacent rows of the light-emitting units 70 on the plane on which the first substrate is located, so that the first electrode layer is disposed by using a row gap between adjacent rows of light-emitting units, and then, on a basis of improving display brightness uniformity of a display picture of the display panel, the light-emitting area of the display panel is not affected.

It should be noted that, in this embodiment of this application, the first electrode line 22 is located in a gap between adjacent rows of light-emitting units 70, and does not affect the light-emitting area of the light-emitting unit 70. Therefore, in this embodiment of this application, in a column direction Y, the first via 21 that electrically connects the first electrode line 22 and the cathode layer 30 may be located in a gap between adjacent columns of the light-emitting unit 70, or may be located in a same column as the light-emitting units 70. This is not limited in this application, and may be specifically determined based on a situation.

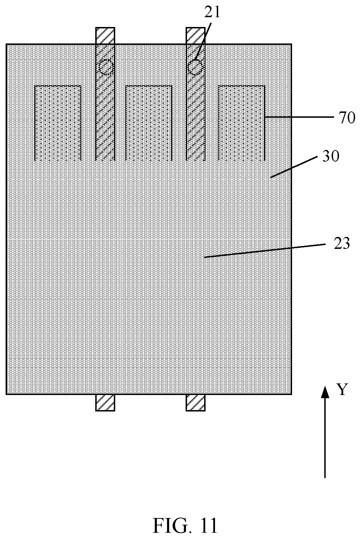

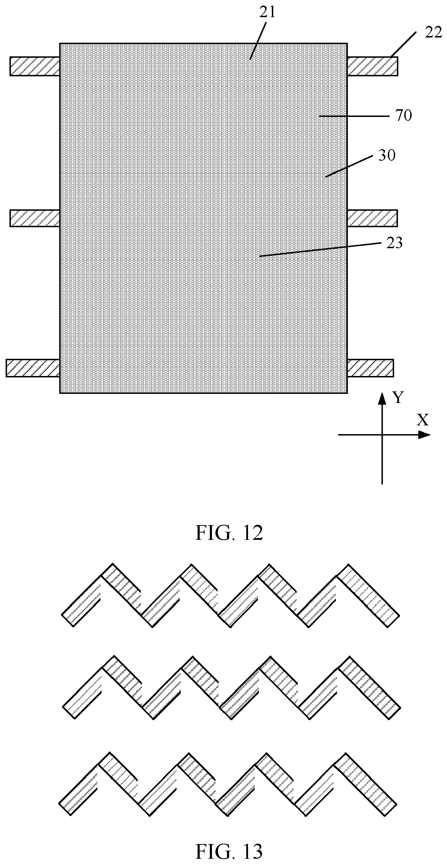

Based on any one of the foregoing embodiments, in an embodiment of this application (not forming part of the claimed invention), as shown in FIG. 11 and FIG. 12, the first electrode layer further includes a plurality of second electrode lines 23, and the second electrode lines 23 extend in a column direction Y; and the plurality of light-emitting units 70 include a plurality of columns of light-emitting units 70, and projection of the second electrode line 23 on the plane on which the first substrate is located is within a projection range of a gap between adjacent columns of the light-emitting units 70 on the plane on which the first substrate is located, so that the first electrode layer is disposed by using a column gap between adjacent columns of light-emitting units, and then, on a basis of improving display brightness uniformity of the display picture of the display panel, the light-emitting area of the display panel is not affected.

It should be noted that, in any one of the foregoing embodiments, a top view of the first electrode layer may be a plurality of strip shapes, as shown in FIG. 10 and FIG. 11, may be a grid shape, as shown in FIG. 12, or may be another shape. This is not limited in this application, and may be determined based on a specific situation.

Based on any one of the foregoing embodiments, in an embodiment of this application, a shape of an electrode line at the first electrode layer is a straight line as shown in FIG. 10 to FIG. 12; in another embodiment of this application, the shape of the electrode line at the first electrode layer is a broken line as shown in FIG. 13; and in still another embodiment of this application, the shape of the electrode line at the first electrode layer may be a wave shape or another shape. This is not limited in this application, and may be specifically determined based on a situation.

It may be learned from the foregoing that, in addition to the first substrate and the cathode layer, the display panel provided in this embodiment of this application further includes a first electrode layer that is connected in parallel to the cathode layer, so as to reduce resistance of a part that is of the cathode layer and that is in the display area by connecting a part of the first electrode layer in parallel to the part that is of the cathode layer and that is in the display area, and then reduce a voltage difference between a part that is of the cathode layer and that is close to a signal input end (that is, a part that is close to the flexible circuit board) and a part that is of the cathode layer and that is away from the signal input end (that is, a part that is away from the flexible circuit board), thereby alleviating non-uniform display brightness of the display panel caused by a large voltage difference between parts of the cathode layer that are in different parts of the display area, and improving display quality of the display panel.

In addition, according to the display panel provided in this embodiment of this application, resistance of the part that is of the cathode layer and that is in the border area is reduced by connecting the part of the first electrode layer in parallel to the part that is of the cathode layer and that is in the border area, so as to reduce a signal transmission loss of the part that is of the cathode layer and that is in the border area, thereby reducing a signal transmission loss that is output by the flexible circuit board and that is transmitted to the part that is of the cathode layer and that is in the display area, and reducing power consumption of the display panel while display brightness of the display panel is fixed.

In addition, an embodiment of this application further provides an electronic device. A display of the electronic device includes the display panel provided in any one of the foregoing embodiments, so as to improve uniformity of display brightness when the electronic device displays a picture, and reduce power consumption of the electronic device when the display brightness of the display panel is fixed. Specifically, in some embodiments, the electronic device may be a device that has a display function, such as a mobile phone, a tablet computer, a desktop computer, a laptop computer, a notebook computer, an ultra-mobile personal computer (Ultra-mobile Personal Computer, UMPC), a handheld computer, a netbook, a personal digital assistant (Personal Digital Assistant, PDA), a wearable electronic device, a smartwatch, an in-vehicle display device, an instrumentation display device, or the like. It should be noted that, in this embodiment of this application, the electronic device may be a foldable display device, or may be a non-foldable display device. This is not limited in this application, and may be specifically determined based on a situation.

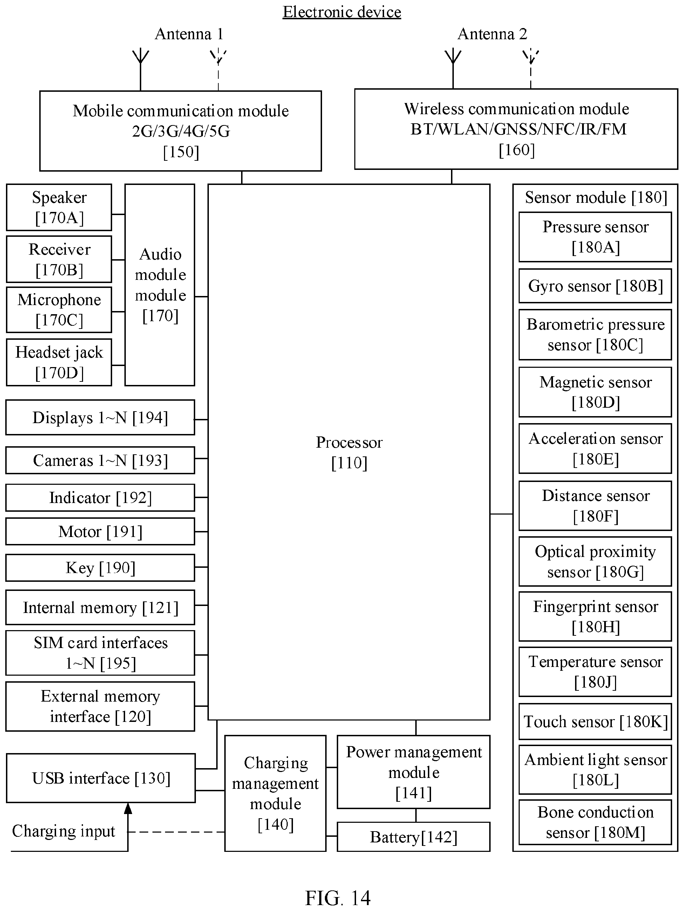

As shown in FIG. 14, in an embodiment of this application, the electronic device may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a key 190, a motor 191, an indicator 192, a camera 193, a display 194, and a subscriber identification module (subscriber identification module, SIM) interface 195. The sensor module 180 may include a pressure sensor 180A, a gyro sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It can be understood that the structure illustrated in this embodiment does not constitute a specific limitation on the electronic device. In some other embodiments, the electronic device may include more or fewer components than those illustrated, or combine some components, or split some components, or have different component arrangements. The illustrated components may be implemented by using hardware, software or a combination of software and hardware.

Specifically, in this embodiment, the electronic device implements a display function by using a GPU, the display 194, an application processor, and the like. The GPU is a microprocessor for image processing, and connects the display 194 to the application processor. The GPU is configured to perform mathematical and geometric calculations for graphics rendering. The processor 110 may include one or more GPUs, where the one or more GPUs execute program instructions to generate or change display information.

The display 194 is configured to display an image, a video, and the like. The display 194 includes a display panel. The display panel may be an organic light-emitting diode (organic light-emitting diode, OLED), an active-matrix organic light emitting diode (active-matrix organic light emitting diode, AMOLED), a Miniled, a MicroLed, a Micro-oled, or the like. In some embodiments, the electronic device may include one or N displays 194, where N is a positive integer greater than 1.

A series of graphical user interfaces (graphical user interface, GUI) may be displayed on the display 194 of the electronic device, and all these GUIs are home screens of the electronic device. Generally, a size of the display 194 of the electronic device is fixed, and only a limited quantity of controls can be displayed on the display 194 of the electronic device. A control is a GUI element. The control is a software component included in an application, and controls all data processed by the application and an interaction operation related to the data. A user may interact with the control through direct manipulation (direct manipulation), so as to read or edit information about the application. Generally, controls may include visual interface elements such as icons, buttons, menus, tabs, text boxes, dialog boxes, status bars, navigation bars, and widgets. For example, in this embodiment of this application, the display 194 may display virtual keys (one-button orchestration, start orchestration, and scenario orchestration).

The foregoing descriptions about implementations allow a person skilled in the art to clearly understand that, for the purpose of convenient and brief description, division of the foregoing function modules is used only as an example for illustration. In actual application, the foregoing functions can be allocated to different function modules and implemented according to needs, that is, an inner structure of an apparatus is divided into different function modules to implement all or some of the functions described above.

In the several embodiments provided in this embodiment, it should be understood that the disclosed system, apparatus, and method may be implemented in another manner. For example, the described apparatus embodiment is merely an example. For example, the module or unit division is merely logical function division and may be another division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one place, or may be distributed on a plurality of network units. Some or all of the units may be selected based on actual needs to achieve the objectives of the solutions of the embodiments.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A display panel, comprising:
a first substrate (10);
a first electrode layer (20) located on a side of the first substrate (10);
a cathode layer (30) located on a side that is of the first electrode layer (20) and that is away from the first substrate (10);
the cathode layer (30) covers a display area (100) of the display panel, and extends to a border area (200) of the display panel; and a part of the first electrode layer (20) is located in the display area (100) of the display panel, is connected in parallel to a part that is of the cathode layer (30) and that is located in the display area (100), and a part of the first electrode layer (20) is located in the border area (200) of the display panel, and is connected in parallel to a part that is of the cathode layer and that is located in the border area (200);
an anode layer (60) located on a side that is of the cathode layer (30) and that faces the first substrate (10);
a pixel definition layer (50) and a light-emitting layer that are located between the anode layer (60) and the cathode layer (30), wherein the pixel definition layer (50) comprises a plurality of pixel definition areas, the light-emitting layer comprises a plurality of light-emitting units (70), and the light-emitting units (70) are in a one-to-one correspondence with the pixel definition areas and are located in the pixel definition areas;
a control circuit (80) layer located on a side that is of the anode layer and that is away from the cathode layer;
the first electrode layer is located on a side that is of the anode layer (60) and that is away from the cathode layer (30), and wherein the first electrode layer (20) is located between the anode layer (60) and the control circuit layer; wherein
the projection of the first electrode layer (20) on a plane on which the first substrate (10) is located at least partially overlaps with the projection of the light-emitting layer (70) on the plane on which the first substrate (10) is located.

2. The display panel according to claim 1, wherein there is a first insulation layer between the control circuit layer and the first electrode layer, and there is a second insulation layer between the first electrode layer and the anode layer, wherein the control circuit layer is electrically connected to the anode layer by using a first via, and the first electrode layer is electrically connected to the cathode layer by using a second via.

3. The display panel according to claim 2, wherein the second via penetrates a gap between adjacent light-emitting units.

4. The display panel according to claim 1, wherein the first electrode layer is located on a side that is of the anode layer and that faces the cathode layer.

5. The display panel according to claim 4, wherein there is a third insulation layer between the anode layer and the first electrode layer, and there is a fourth insulation layer between the first electrode layer and the cathode layer.

6. The display panel according to any one of claims 1 to 5, wherein the first electrode layer comprises a plurality of first electrode lines, the plurality of light-emitting units comprise a plurality of rows of light-emitting units, the first electrode lines extend in a row direction, and projection of the first electrode line on the plane on which the first substrate is located is within a projection range of a gap between adjacent rows of the light-emitting units on the plane on which the first substrate is located.

7. The display panel according to claim 6, wherein the first electrode layer further comprises a plurality of second electrode lines, the second electrode lines extend in a column direction, the plurality of light-emitting units comprise a plurality of columns of light-emitting units, and projection of the second electrode line on the plane on which the first substrate is located is within a projection range of a gap between adjacent columns of the light-emitting units on the plane on which the first substrate is located.

8. The display panel according to any one of claims 1 to 6, wherein a shape of an electrode line at the first electrode layer is a wave shape or a broken line shape.

9. An electronic device, wherein a display of the electronic device comprises the display panel according to any one of claims 1 to 8.

## Patentansprüche

1. Anzeigefeld, umfassend:
ein erstes Substrat (10);
eine erste Elektrodenschicht (20), die sich auf einer Seite des ersten Substrats (10) befindet;
eine Kathodenschicht (30), die sich auf einer Seite der ersten Elektrodenschicht (20) befindet, und die von dem ersten Substrat (10) entfernt ist;
wobei die Kathodenschicht (30) einen Anzeigebereich (100) des Anzeigefelds bedeckt, und sich bis zu einem Randbereich (200) des Anzeigefelds erstreckt; und sich ein Teil der ersten Elektrodenschicht (20) in dem Anzeigebereich (100) des Anzeigefelds befindet, parallel zu einem Teil geschaltet ist, der von der Kathodenschicht (30) ist, und der sich in dem Anzeigebereich (100) befindet, und sich ein Teil der ersten Elektrodenschicht (20) in dem Randbereich (200) des Anzeigefelds befindet, und parallel zu einem Teil geschaltet ist, der von der Kathodenschicht ist, und der sich in dem Randbereich (200) befindet;
eine Anodenschicht (60), die sich auf einer Seite der Kathodenschicht (30) befindet und dem ersten Substrat (10) zugewandt ist;
eine Pixeldefinitionsschicht (50) und eine Licht emittierende Schicht, die sich zwischen der Anodenschicht (60) und der Kathodenschicht (30) befinden, wobei die Pixeldefinitionsschicht (50) eine Vielzahl von Pixeldefinitionsbereichen umfasst, die Licht emittierende Schicht eine Vielzahl von Licht emittierenden Einheiten (70) umfasst, und die Licht emittierenden Einheiten (70) in einer Eins-zu-eins-Entsprechung zu den Pixeldefinitionsbereichen sind und sich in den Pixeldefinitionsbereichen befinden;
eine Steuerschaltungs(80)-Schicht, die sich auf einer Seite der Anodenschicht befindet und von der Kathodenschicht entfernt ist;
wobei sich die erste Elektrodenschicht auf einer Seite der Anodenschicht (60) befindet, die von der Kathodenschicht (30) entfernt ist, und wobei sich die erste Elektrodenschicht (20) zwischen der Anodenschicht (60) und der Steuerschaltungsschicht befindet; wobei
die Projektion der ersten Elektrodenschicht (20) auf eine Ebene, auf der sich das erste Substrat (10) befindet, mindestens teilweise mit der Projektion der Licht emittierenden Schicht (70) auf die Ebene überlappt, auf der sich das erste Substrat (10) befindet.

2. Anzeigefeld nach Anspruch 1, wobei es eine erste Isolierschicht zwischen der Steuerschaltungsschicht und der ersten Elektrodenschicht gibt, und es eine zweite Isolierschicht zwischen der ersten Elektrodenschicht und der Anodenschicht gibt, wobei die Steuerschaltungsschicht mit der Anodenschicht unter Verwendung einer ersten Durchkontaktierung elektrisch verbunden ist, und die erste Elektrodenschicht mit der Kathodenschicht durch Verwendung einer zweiten Durchkontaktierung elektrisch verbunden ist.

3. Anzeigefeld nach Anspruch 2, wobei die zweite Durchkontaktierung ein Lücke zwischen angrenzenden Licht emittierenden Einheiten durchdringt.

4. Anzeigefeld nach Anspruch 1, wobei sich die erste Elektrodenschicht auf einer Seite befindet, die von der Anodenschicht ist, die der Kathodenschicht zugewandt ist.

5. Anzeigefeld nach Anspruch 4, wobei es eine dritte Isolierschicht zwischen der Anodenschicht und der ersten Elektrodenschicht gibt, und es eine vierte Isolierschicht zwischen der ersten Elektrodenschicht und der Kathodenschicht gibt.

6. Anzeigefeld nach einem der Ansprüche 1 bis 5, wobei die erste Elektrodenschicht eine Vielzahl von ersten Elektrodenleitungen umfasst, die Vielzahl von Licht emittierenden Einheiten eine Vielzahl von Reihen von Licht emittierenden Einheiten umfasst, die ersten Elektrodenleitungen sich in einer Reihenrichtung erstrecken und die Projektion der ersten Elektrodenleitung auf die Ebene, auf der sich das erste Substrat befindet, innerhalb eines Projektionsbereichs einer Lücke zwischen angrenzenden Reihen der Licht emittierenden Einheiten auf der Ebene liegt, auf der sich das erste Substrat befindet.

7. Anzeigefeld nach Anspruch 6, wobei die erste Elektrodenschicht ferner eine Vielzahl von zweiten Elektrodenleitungen umfasst, die zweiten Elektrodenleitungen sich in einer Spaltenrichtung erstrecken, die Vielzahl von Licht emittierenden Einheiten eine Vielzahl von Spalten von Licht emittierenden Einheiten umfasst und die Projektion der zweiten Elektrodenleitung auf die Ebene, auf der sich das erste Substrat befindet, innerhalb eines Projektionsbereichs einer Lücke zwischen angrenzenden Spalten der Licht emittierenden Einheiten auf der Ebene liegt, auf der sich das erste Substrat befindet.

8. Anzeigefeld nach einem der Ansprüche 1 bis 6, wobei eine Form einer Elektrodenleitung an der ersten Elektrodenschicht eine Wellenform oder eine unterbrochene Linienform ist.

9. Elektronische Vorrichtung, wobei eine Anzeige der elektronischen Vorrichtung das Anzeigefeld nach einem der Ansprüche 1 bis 8 umfasst.

## Revendications

1. Écran d'affichage, comprenant :
un premier substrat (10) ;
une première couche d'électrode (20) située sur un côté du premier substrat (10) ;
une couche cathodique (30) située sur un côté de la première couche d'électrode (20) et qui est éloigné du premier substrat (10) ;
la couche cathodique (30) recouvre une zone d'affichage (100) de l'écran d'affichage et s'étend jusqu'à une zone de bordure (200) de l'écran d'affichage ; et une partie de la première couche d'électrode (20) est située dans la zone d'affichage (100) de l'écran d'affichage, est connectée en parallèle à une partie de la couche cathodique (30) et qui est située dans la zone d'affichage (100), et une partie de la première couche d'électrode (20) est située dans la zone de bordure (200) de l'écran d'affichage, et est connectée en parallèle à une partie de la couche cathodique et qui est située dans la zone de bordure (200) ;
une couche anodique (60) située sur un côté de la couche cathodique (30) et qui fait face au premier substrat (10) ;
une couche de définition de pixels (50) et une couche d'émission de lumière qui sont situées entre la couche anodique (60) et la couche cathodique (30), dans lequel la couche de définition de pixels (50) comprend une pluralité de zones de définition de pixels, la couche d'émission de lumière comprend une pluralité d'unités d'émission de lumière (70), et les unités d'émission de lumière (70) sont en correspondance biunivoque avec les zones de définition de pixels et sont situées dans les zones de définition de pixels ;
une couche de circuit de commande (80) située sur un côté de la couche anodique et qui est éloigné de la couche cathodique ;
la première couche d'électrode est située sur un côté de la couche anodique (60) et qui est éloigné de la couche cathodique (30), et dans lequel la première couche d'électrode (20) est située entre la couche anodique (60) et la couche de circuit de commande ; dans lequel
la projection de la première couche d'électrodes (20) sur un plan sur lequel le premier substrat (10) est situé se superpose au moins partiellement à la projection de la couche d'émission de lumière (70) sur le plan sur lequel le premier substrat (10) est situé.

2. Écran d'affichage selon la revendication 1, dans lequel il y a une première couche d'isolation entre la couche de circuit de commande et la première couche d'électrode, et il y a une deuxième couche d'isolation entre la première couche d'électrode et la couche anodique, dans lequel la couche de circuit de commande est connectée électriquement à la couche anodique à l'aide d'un premier trou d'interconnexion, et la première couche d'électrode est connectée électriquement à la couche cathodique à l'aide d'un second trou d'interconnexion.

3. Écran d'affichage selon la revendication 2, dans lequel le second trou d'interconnexion pénètre dans un espace entre des unités d'émission de lumière adjacentes.

4. Écran d'affichage selon la revendication 1, dans lequel la première couche d'électrode est située sur un côté de la couche anodique et qui fait face à la couche cathodique.

5. Écran d'affichage selon la revendication 4, dans lequel il y a une troisième couche d'isolation entre la couche anodique et la première couche d'électrode, et une quatrième couche d'isolation entre la première couche d'électrode et la couche cathodique.

6. Écran d'affichage selon l'une quelconque des revendications 1 à 5, dans lequel la première couche d'électrode comprend une pluralité de premières lignes d'électrode, la pluralité d'unités d'émission de lumière comprennent une pluralité de rangées d'unités d'émission de lumière, les premières lignes d'électrode s'étendent dans une direction de rangée, et la projection de la première ligne d'électrode sur le plan sur lequel le premier substrat est situé est à l'intérieur d'une plage de projection d'un espace entre des rangées adjacentes des unités d'émission de lumière sur le plan sur lequel le premier substrat est situé.

7. Écran d'affichage selon la revendication 6, dans lequel la première couche d'électrode comprend en outre une pluralité de secondes lignes d'électrode, les secondes lignes d'électrode s'étendent dans une direction de colonne, la pluralité d'unités d'émission de lumière comprennent une pluralité de colonnes d'unités d'émission de lumière, et la projection de la seconde ligne d'électrode sur le plan sur lequel le premier substrat est situé est à l'intérieur d'une plage de projection d'un espace entre des colonnes adjacentes d'unités d'émission de lumière sur le plan sur lequel le premier substrat est situé.

8. Écran d'affichage selon l'une quelconque des revendications 1 à 6, dans lequel une forme d'une ligne d'électrode dans la première couche d'électrode est une forme d'onde ou une forme de ligne brisée.

9. Dispositif électronique, dans lequel un afficheur du dispositif électronique comprend l'écran d'affichage selon l'une quelconque des revendications 1 à 8.
